# EUROPEAN PATENT SPECIFICATION

(11) **EP 4 517 353 B1**
(45) Date of publication and mention of the grant of the patent: **02.12.2026**
(21) Application number: 23883146.5
(22) Date of filing: 26.10.2023
(51) Int. Cl.: G01R 31/3842, G01R 19/00, G01R 19/165, G01R 31/392, G01R 31/396, H01M 10/052, H01M 10/48

(54) **APPARATUS AND METHOD FOR DIAGNOSING BATTERY**
VORRICHTUNG UND VERFAHREN ZUR BATTERIEDIAGNOSE
APPAREIL ET PROCÉDÉ DE DIAGNOSTIC DE BATTERIE

(30) Priority: 26.10.2022 KR 20220139216
(43) Date of publication of application: 05.03.2025
(73) Proprietor: LG Energy Solution, Ltd., Seoul 07335 (KR)
(72) Inventor: JEONG, Hee-Seok, Daejeon 34122 (KR); BAE, Yoon-Jung, Daejeon 34122 (KR)
(74) Representative: Goddar, Heinz J.
(86) International application number: PCT/KR2023/016799
(87) International publication number: WO 2024/091041

(56) References cited:
- JP-A- 2022 503 510
- KR-A- 20200 111 014
- KR-A- 20210 074 003
- KR-A- 20220 019 637
- KR-A- 20220 037 047
- KR-A- 20220 100 471
- KR-B1- 100 927 541
- US-A1- 2021 318 388
- US-A1- 2021 325 476
- US-A1- 2022 176 845

## Description

### TECHNICAL FIELD

The present application claims priority to Korean Patent Application No. 10-2022-0139216 filed on October 26, 2022 in the Republic of Korea.

The present disclosure relates to an apparatus and method for diagnosing a battery, and more particularly, to an apparatus and method for diagnosing a battery, which is capable of diagnosing a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As power-driven devices such as electric vehicles, electric motorcycles, and electric bicycles are commercialized, the demand for high-capacity and high-performance batteries is increasing. For example, a plurality of battery cells may be connected in series and/or parallel to form a battery module.

However, because the plurality of battery cells connected to each other are not deteriorated equally, there is a problem in that the state of each of the plurality of battery cells cannot be accurately diagnosed based on the state of the battery module.

US 2021/325476 A1 discloses a battery state estimating apparatus including a voltage measuring unit configured to measure a voltage of a battery cell and measure an open circuit voltage (OCV) of the battery cell whenever the measured voltage reaches a reference discharge voltage and a control unit configured to receive the OCV measured by the voltage measuring unit, compare the received OCV with a pre-stored reference voltage to calculate a voltage fluctuation rate, determine a voltage increase and decrease pattern based on the calculated voltage fluctuation rate and pre-stored voltage fluctuation rate data, and determine a degradation acceleration degree of the battery cell according to the determined voltage increase and decrease pattern.

### DISCLOSURE

### Technical Problem

The present disclosure is designed to solve the problems of the related art, and therefore the present disclosure is directed to providing an apparatus and method for diagnosing a battery, which diagnoses a state of each of a plurality of batteries connected to each other.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may diagnoses states of a plurality of battery cells included in a battery module.

The apparatus for diagnosing a battery may comprises a measuring unit configured to measure voltages of the battery module and each of the plurality of battery cells; and a control unit configured to determine a voltage of each of the plurality of battery cells when the voltage of the battery module reaches a preset cut-off voltage, determine a voltage increase/decrease pattern of each of the plurality of battery cells based on the determined plurality of voltages and previously stored voltage data, and diagnose the state of each of the plurality of battery cells according to the determined voltage increase/decrease pattern.

The previously stored voltage data may be set to include a reference voltage of the plurality of battery cells measured each time the voltage of the battery module reaches the cut-off voltage.

The control unit may be configured to determine the voltage increase/decrease pattern for each of the plurality of battery cells based on the determined voltage and at least one reference voltage included in the previously stored voltage data.

The control unit may be configured to derive a relationship between the determined voltage and the at least one reference voltage for each of the plurality of battery cells, and determine the voltage increase/decrease pattern for each of the plurality of battery cells based on the derived relationship.

The control unit may be configured to diagnose the state of the battery cell depending on whether the determined voltage increase/decrease pattern is toward the cut-off voltage.

The control unit may be configured to determine a charging voltage of each of the plurality of battery cells when the voltage of the battery module reaches a preset charging cut-off voltage, and determine a first voltage increase/decrease pattern of each of the plurality of battery cells based on the determined charging voltage and the previously stored voltage data.

The control unit may be configured to determine a discharging voltage of each of the plurality of battery cells when the voltage of the battery module reaches a preset discharging cut-off voltage, and determine a second voltage increase/decrease pattern of each of the plurality of battery cells based on the determined discharging voltage and the previously stored voltage data.

The control unit may be configured to diagnose the state of each of the plurality of battery cells based on the first voltage increase/decrease pattern and the second voltage increase/decrease pattern.

The control unit may be configured to diagnose the state of a battery cell in which the first voltage increase/decrease pattern is a voltage increase pattern and the second voltage increase/decrease pattern is a voltage decrease pattern as an accelerated deterioration state.

The control unit may be configured to diagnose the state of a battery cell in which the first voltage increase/decrease pattern is a voltage decrease pattern and the second voltage increase/decrease pattern is a voltage increase pattern as a slow deterioration state.

The measuring unit may be configured to further measure a current of the battery module.

The control unit may be configured to calculate a capacity of the battery module based on the current of the battery module, and diagnose the state of each of the plurality of battery cells when the calculated capacity is reduced compared to a previously calculated capacity.

The control unit may be configured to diagnose the state of the remaining battery cells among the plurality of battery cells, excluding battery cells whose determined voltage is the same as the cut-off voltage, when the capacity of the battery module is within a preset range from a preset initial capacity.

A battery pack according to another aspect of the present disclosure may comprise the apparatus for diagnosing a battery according to one aspect of the present disclosure.

A method for diagnosing a battery according to still another aspect of the present disclosure may diagnoses states of a plurality of battery cells included in a battery module.

The method for diagnosing a battery may comprise a voltage measuring step of measuring voltages of the battery module and each of the plurality of battery cells; a voltage determining step of determining a voltage of each of the plurality of battery cells when the voltage of the battery module reaches a preset cut-off voltage; a voltage increase/decrease pattern determining step of determining a voltage increase/decrease pattern of each of the plurality of battery cells based on the determined plurality of voltages and previously stored voltage data; and a battery diagnosing step of diagnosing the state of each of the plurality of battery cells according to the determined voltage increase/decrease pattern.

### Advantageous Effects

According to one aspect of the present disclosure, the apparatus for diagnosing a battery has the advantage of specifically diagnosing the state of each of a plurality of battery cells by considering whether charging and discharging of the battery module is terminated and the voltage increase/decrease pattern of the plurality of battery cells.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a diagnostic rule according to an embodiment of the present disclosure.
FIG. 3 is a diagram schematically showing a charging voltage of a battery module and a plurality of battery cells according to an embodiment of the present disclosure.
FIG. 4 is a diagram schematically showing a discharging voltage of a battery module and a plurality of battery cells according to an embodiment of the present disclosure.
FIG. 5 is a diagram schematically showing an exemplary configuration of a battery pack according to another embodiment of the present disclosure.
FIG. 6 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure as defined by the appended claims.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

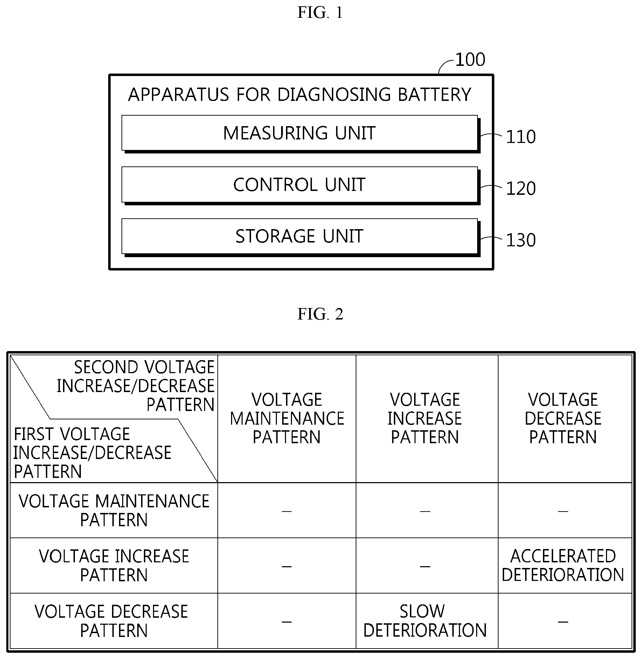

FIG. 1 is a diagram schematically illustrating an apparatus 100 for diagnosing a battery according to an embodiment of the present disclosure.

The apparatus 100 for diagnosing a battery is configured to diagnose a state of a battery cell included in a battery module.

Here, the battery cell refers to an independent cell that has a negative terminal and a positive terminal and is physically separable. As an example, one lithium-ion battery or one lithium polymer battery may be considered as a battery cell. Additionally, a plurality of battery cells may be connected in series and/or parallel to configure a battery module. Additionally, depending on the embodiment, a plurality of battery cells may be connected in series and/or parallel to configure a battery pack. Below, for convenience of explanation, a plurality of battery cells included in a battery module will be explained, but it should be noted that the present disclosure may also be applied to a plurality of battery cells included in a battery pack.

Referring to FIG. 1, the apparatus 100 for diagnosing a battery includes a measuring unit 110 and a control unit 120.

The measuring unit 110 is configured to measure the voltage of a battery module and each of a plurality of battery cells.

Specifically, the measuring unit 110 may be electrically connected to a positive electrode terminal and a negative electrode terminal of the battery module. Additionally, the measuring unit 110 may measure the voltage of the battery module by measuring the positive electrode voltage and the negative electrode voltage of the battery module.

Additionally, the measuring unit 110 may be electrically connected to a positive electrode terminal and a negative electrode terminal of each of the plurality of battery cells included in the battery module. Additionally, the measuring unit 110 may measure the voltage of each battery cell by measuring the positive electrode voltage and the negative electrode voltage of each of the plurality of battery cells.

The measuring unit 110 may be connected to the control unit 120 to enable communication. For example, the measuring unit 110 may be connected to the control unit 120 wired and/or wirelessly. The measuring unit 110 may transmit information about the measured voltage of the battery module and the plurality of battery cells to the control unit 120.

The control unit 120 is configured to determine the voltage of each of the plurality of battery cells when the voltage of the battery module reaches a preset cut-off voltage.

Specifically, the cut-off voltage for the battery module may be set in advance. Here, the cut-off voltage may include a charging end voltage and a discharging end voltage of the battery module. For example, when the voltage of the battery module reaches the charging cut-off voltage, charging of the battery module may be terminated. As another example, when the voltage of the battery module reaches the discharging cut-off voltage, discharging of the battery module may be terminated.

For example, assuming that the voltage of the battery module reaches the charging cut-off voltage at the time point a, the control unit 120 may determine the voltage of each of the plurality of battery cells measured at the time point a.

As another example, assuming that the voltage of the battery module at the time point b reaches the discharging cut-off voltage, the control unit 120 may determine the voltage of each of the plurality of battery cells measured at the time point b.

The control unit 120 is configured to determine a voltage increase/decrease pattern of each of the plurality of battery cells based on the determined plurality of voltages and previously stored voltage data.

Here, the previously stored voltage data may be set to include reference voltages of the plurality of battery cells measured each time the voltage of the battery module reaches the cut-off voltage. Specifically, the previously stored voltage data may include data about the voltage of the battery module and the plurality of battery cells measured at past time points. Preferably, the previously stored voltage data may include data about the voltage of the plurality of battery cells determined each time the voltage of the battery module reached the cut-off voltage at a past time point.

The control unit 120 may be configured to determine a voltage increase/decrease pattern for each of the plurality of battery cells based on the determined voltage and at least one reference voltage included in the previously stored voltage data. Here, the voltage increase/decrease pattern is a pattern that may indicate the current trend of the voltage of the battery cell, and may be determined through comparison between the reference voltage of the battery cell measured at a past time point and the voltage of the battery cell measured at the current time point.

Preferably, the voltage increase/decrease pattern may be classified into a voltage increase pattern or a voltage decrease pattern. Here, the voltage maintenance pattern is a pattern in which the voltage of the battery cell is maintained constant from the past to the present. The voltage increase pattern is a pattern in which the voltage of the battery cell tends to increase compared to the past. The voltage decrease pattern is a pattern in which the voltage of the battery cell tends to decrease compared to the past.

For example, assume that the battery module includes one battery cell, the current time point is a time point t+3, and the previously stored voltage data includes the reference voltages of the battery module and the battery cell at time points t, t+1, and t+2. The control unit 120 may determine a voltage increase/decrease pattern for the voltage of the battery cell measured at the time points t, t+1, t+2, and t+3 and the reference voltages. A specific embodiment of determining the voltage increase/decrease pattern will be described later.

The control unit 120 is configured to diagnose the state of each of the plurality of battery cells according to the determined voltage increase/decrease pattern.

Specifically, the control unit 120 may diagnose the deterioration state of the battery cell according to the voltage increase/decrease pattern. Preferably, the control unit 120 may diagnose the deterioration progress state of the battery cell.

For example, the control unit 120 may diagnose the state of the battery cell as an accelerated deterioration state or a slow deterioration state.

Here, the slow deterioration state may refer to a state in which the battery cell is deteriorated according to a general deterioration speed. In other words, a battery cell in a slow deterioration state may be a battery cell in a normal state that is being deteriorated at a predictable deterioration speed. Conversely, the accelerated deterioration state may refer to a state in which deterioration of a battery cell progresses rapidly. In other words, a battery cell in an accelerated deterioration state may be a battery cell in an abnormal state that is rapidly deteriorating outside the predicted range. The predictable deterioration speed and the range of predictable deterioration speed that may distinguish the accelerated deterioration state and the slow deterioration state may be appropriately set through experiment or simulation.

Generally, when charging and discharging of the battery module ends, charging and discharging of the plurality of battery cells included in the battery module also ends. In other words, the charging and discharging end time point of the battery module may be a standard time point for determining the change of state of the plurality of battery cells. For example, when using a specific SOC or specific capacity of the battery module as a standard time point, if the capacity of the battery module decreases due to deterioration, the standard time point may change. On the other hand, if the charging and discharging end time point of the battery module is used as the standard, the state of the plurality of battery cells may be diagnosed using the same standard even if the capacity of the battery module varies.

Therefore, the apparatus 100 for diagnosing a battery according to an embodiment of the present disclosure has the advantage of specifically diagnosing the state of each of the plurality of battery cells by considering whether charging and discharging of the battery module is terminated and the voltage increase/decrease pattern of the plurality of battery cells.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store voltage data about the reference voltage of the plurality of battery cells. The control unit 120 may access the storage unit 130 to obtain the stored voltage data.

Below, an embodiment in which the control unit 120 determines the voltage increase/decrease pattern of the battery cell based on the voltage and the reference voltage will be described.

According to an embodiment of the present disclosure, the control unit 120 may be configured to derive a relationship between the determined voltage and at least one reference voltage for each of the plurality of battery cells.

For example, the control unit 120 may derive a relationship between the determined voltage and at least one reference voltage using a fitting algorithm. Here, the derived relationship may be a function that may represent the reference voltage of the battery cell at a past time point and the voltage of the battery cell at the current time point.

The control unit 120 may be configured to determine the voltage increase/decrease pattern for each of the plurality of battery cells based on the derived relationship.

For example, the control unit 120 may calculate the instantaneous change rate for the current time point based on the derived relationship. Additionally, the control unit 120 may determine the voltage increase/decrease pattern of the battery cell according to the calculated instantaneous change rate. If the instantaneous change rate is a positive number, the control unit 120 may determine the voltage increase/decrease pattern of the battery cell as a voltage increase pattern. If the instantaneous change rate is 0, the control unit 120 may determine the voltage increase/decrease pattern of the battery cell as a voltage maintenance pattern. If the instantaneous change rate is negative, the control unit 120 may determine the voltage increase/decrease pattern of the battery cell as a voltage decrease pattern.

The apparatus 100 for diagnosing a battery according to an embodiment of the present disclosure has the advantage of accurately determining the voltage increase/decrease pattern for a plurality of battery cells according to the relationship between the current voltage and the past reference voltages. According to the voltage increase/decrease pattern determined in this way, the state of the plurality of battery cells may be diagnosed with high accuracy.

The control unit 120 may be configured to diagnose the state of the battery cell depending on whether the determined voltage increase/decrease pattern is toward the cut-off voltage.

Specifically, the control unit 120 may determine the first voltage increase/decrease pattern of each of the plurality of battery cells in the charging process of the battery module, and determine the second voltage increase/decrease pattern of each of the plurality of battery cells in the discharging process of the battery module. Here, the first voltage increase/decrease pattern and the second voltage increase/decrease pattern may be independent patterns. In other words, the first voltage increase/decrease pattern may not affect the second voltage increase/decrease pattern.

The control unit 120 may be configured to determine the charging voltage of each of the plurality of battery cells when the voltage of the battery module reaches the preset charging cut-off voltage. The control unit 120 may be configured to determine the first voltage increase/decrease pattern of each of the plurality of battery cells based on the determined charging voltage and the previously stored voltage data.

For example, the control unit 120 may determine the first voltage increase/decrease pattern of each of the plurality of battery cells based on the determined charging voltage and the reference charging voltage included in the previously stored voltage data.

Additionally, the control unit 120 may be configured to determine the discharging voltage of each of the plurality of battery cells when the voltage of the battery module reaches the preset discharging cut-off voltage. The control unit 120 may be configured to determine the second voltage increase/decrease pattern of each of the plurality of battery cells based on the determined discharging voltage and the previously stored voltage data.

For example, the control unit 120 may determine the second voltage increase/decrease pattern of each of the plurality of battery cells based on the determined discharging voltage and the reference discharging voltage included in the previously stored voltage data.

Additionally, the control unit 120 may be configured to diagnose the state of each of the plurality of battery cells based on the first voltage increase/decrease pattern and the second voltage increase/decrease pattern.

FIG. 2 is a diagram schematically showing a diagnostic rule according to an embodiment of the present disclosure. Specifically, FIG. 2 is a diagram showing the state of a battery cell diagnosed according to the first voltage increase/decrease pattern and the second voltage increase/decrease pattern of the battery cell.

Referring to FIG. 2, the control unit 120 may diagnose the state of the battery cell as an accelerated deterioration state or a slow deterioration state by considering both the first voltage increase/decrease pattern and the second voltage increase/decrease pattern.

For example, the control unit 120 may diagnose the state of a battery cell in which the first voltage increase/decrease pattern is a voltage increase pattern and the second voltage increase/decrease pattern is a voltage decrease pattern as an accelerated deterioration state.

As another example, the control unit 120 may diagnose the state of a battery cell in which the first voltage increase/decrease pattern is a voltage decrease pattern and the second voltage increase/decrease pattern is a voltage increase pattern as a slow deterioration state.

The apparatus 100 for diagnosing a battery according to an embodiment of the present disclosure has the advantage of being able to diagnose the state of the battery cell more accurately by considering both the first voltage increase/decrease pattern (voltage increase/decrease pattern in a charging state) and the second voltage increase/decrease pattern (voltage increase/decrease pattern in a discharging state), which are independent of each other.

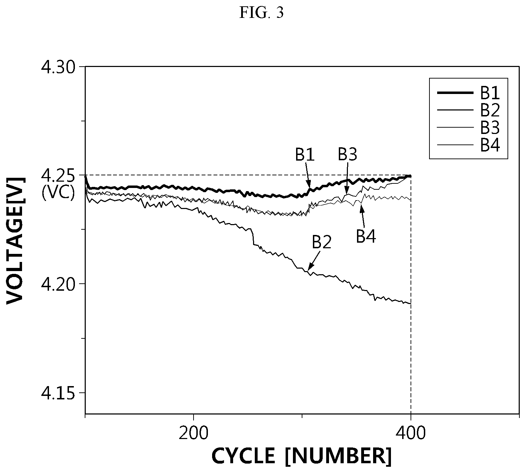

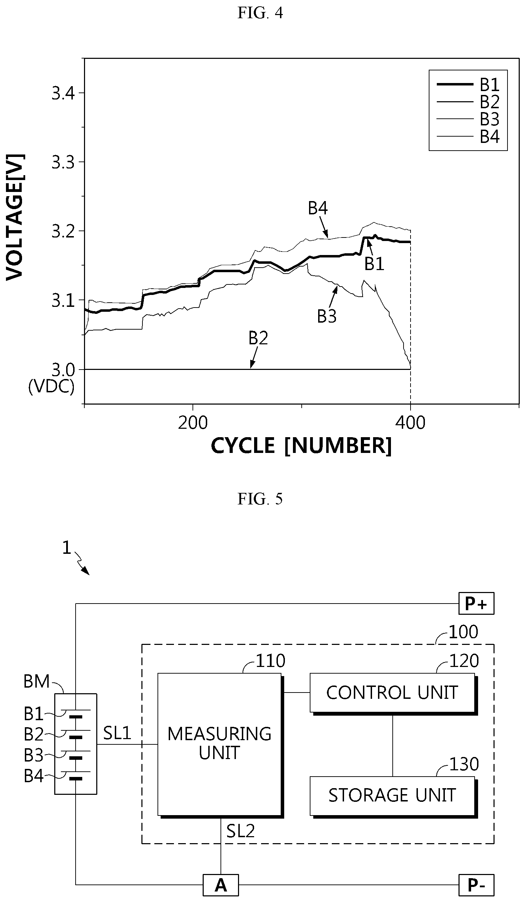

FIG. 3 is a diagram schematically showing a charging voltage of a battery module and a plurality of battery cells according to an embodiment of the present disclosure. FIG. 4 is a diagram schematically showing a discharging voltage of a battery module and a plurality of battery cells according to an embodiment of the present disclosure.

Specifically, FIG. 3 is a diagram showing the charging voltage of the first battery cell B 1, the second battery cell B2, the third battery cell B3, and the fourth battery cell B4 and the charging cut-off voltage VC of the battery module. More specifically, FIG. 3 is a diagram showing the charging reference voltage of the plurality of battery cells B1, B2, B3, B4 included in the previously stored voltage data and the voltage determined in the current cycle (400 cycle). FIG. 4 is a diagram showing the discharging voltage of the first battery cell B1, the second battery cell B2, the third battery cell B3, and the fourth battery cell B4 and the discharging cut-off voltage VDC of the battery module. More specifically, FIG. 4 is a diagram showing the discharging reference voltage of the plurality of battery cells B1, B2, B3, B4 and the voltage determined in the current cycle (400 cycle). Below, the voltage increase/decrease pattern of the plurality of battery cells B1, B2, B3, B4 is explained based on 400 cycle.

In the embodiment of FIG. 3, based on 400 cycle, the voltage of the first battery cell B1 and the third battery cell B3 may be increasing, the voltage of the fourth battery cell B4 may be maintained, and the voltage of the second battery cell B2 may be decreasing. Therefore, the first voltage increase/decrease pattern of the first battery cell B1 and the third battery cell B3 may be determined as the voltage increase pattern. The first voltage increase/decrease pattern of the fourth battery cell B4 may be determined as the voltage maintenance pattern. The first voltage increase/decrease pattern of the second battery cell B2 may be determined as the voltage decrease pattern.

In the embodiment of FIG. 4, based on 400 cycle, the voltage of the first battery cell B1 and the second battery cell B2 may be maintained, the voltage of the third battery cell B3 may be decreasing, and the voltage of the fourth battery cell B4 may be decreasing. Therefore, the second voltage increase/decrease pattern of the first battery cell B1 and the second battery cell B2 may be determined as the voltage maintenance pattern. The second voltage increase/decrease pattern of the third battery cell B3 may be determined as the voltage decrease pattern. The second voltage increase/decrease pattern of the fourth battery cell B4 may be determined as the voltage decrease pattern.

In summary, the first voltage increase/decrease pattern of the first battery cell B1 may be determined as a voltage increase pattern, and the second voltage increase/decrease pattern may be determined as a voltage maintenance pattern. The first voltage increase/decrease pattern of the second battery cell B2 may be determined as a voltage decrease pattern, and the second voltage increase/decrease pattern may be determined as a voltage maintenance pattern. The first voltage increase/decrease pattern of the third battery cell B3 may be determined as a voltage increase pattern, and the second voltage increase/decrease pattern may be determined as a voltage decrease pattern. The first voltage increase/decrease pattern of the fourth battery cell B4 may be determined as a voltage maintenance pattern, and the second voltage increase/decrease pattern may be determined as a voltage decrease pattern.

Referring to FIG. 3, the control unit 120 may diagnose the state of the third battery cell B3 in which the first voltage increase/decrease pattern is a voltage increase pattern and the second voltage increase/decrease pattern is a voltage decrease pattern as an accelerated deterioration state.

In one embodiment, the measuring unit 110 may be configured to further measure the current of the battery module.

Specifically, the measuring unit 110 may measure the charging current applied to the battery module and the discharging current output from the battery module.

The control unit 120 may be configured to calculate the capacity of the battery module based on the current of the battery module.

The control unit 120 may be configured to diagnose the state of each of the plurality of battery cells when the calculated capacity is reduced compared to the previously calculated capacity. The control unit 120 first determines whether the capacity of the battery module is reduced, and when it is confirmed that the capacity is reduced, the control unit 120 may determine the voltage increase/decrease pattern for each of the plurality of battery cells.

For example, when the capacity of the battery module calculated at the current time point is reduced compared to the capacity of the battery module calculated at the previous time point, the control unit 120 may determine a voltage increase/decrease pattern for each of the plurality of battery cells. Here, the capacity of the battery module calculated at the previous time point may be stored in the storage unit 130. Additionally, the control unit 120 may store the capacity of the battery calculated at the current time point in the storage unit 130.

The apparatus 100 for diagnosing a battery according to an embodiment of the present disclosure may determine the voltage increase/decrease pattern of the plurality of battery cells only when necessary by determining whether the capacity of the battery module is reduced in advance. In other words, if the capacity of the battery module is not reduced, it is possible to prevent system resources required to determine the voltage increase/decrease pattern of the plurality of battery cells from being unnecessarily used.

In one embodiment, when the capacity of the battery module is within a preset range from a preset initial capacity, the control unit 120 may be configured to diagnose the state of the remaining battery cells, excluding battery cells whose determined voltage is the same as the cut-off voltage, among the plurality of battery cells.

Specifically, when the capacity of the battery module is within a preset range from the preset initial capacity, a battery cell (hereinafter referred to as a diagnosis pending cell) whose determined voltage is equal to the cut-off voltage may correspond to a battery cell with a large initial resistance or a small initial capacity. In other words, depending on its characteristics, the voltage of the diagnosis pending cell in the initial cycle may appear to be the same as the cut-off voltage of the battery module. Therefore, in order to increase diagnosis accuracy, the apparatus 100 for diagnosing a battery may diagnose the state only for battery cells excluding diagnosis pending cells among the plurality of battery cells.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the measuring unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 5 is a diagram schematically showing an exemplary configuration of a battery pack according to another embodiment of the present disclosure.

The positive electrode terminal of the battery module may be electrically connected to the positive electrode terminal P+ of the battery pack. The negative electrode terminal of the battery module may be electrically connected to the negative electrode terminal P- of the battery pack.

In the battery module, the first battery cell B1, the second battery cell B2, the third battery cell B3, and the fourth battery cell B4 may be connected in series. Note that although the embodiment of FIG. 5 shows an embodiment in which the battery cells are connected in series, a plurality of battery cells may be connected in series and/or parallel.

The measuring unit 110 may be connected to a first sensing line and a second sensing line.

The measuring unit 110 may be electrically connected to the battery module through the first sensing line. Additionally, the measuring unit 110 may measure the voltage of the battery module and the voltage of the plurality of battery cells B1, B2, B3, B4 through the first sensing line.

The measuring unit 110 may be electrically connected to a current measuring unit through the second sensing line. For example, the current measuring unit may be an ampere meter or a shunt resistor. The measuring unit 110 may measure the charging current and the discharging current of the battery module through the second sensing line.

An external device may be electrically connected to the positive electrode terminal P+ and the negative electrode terminal P- of the battery pack. For example, the external device may be a charging device or a load.

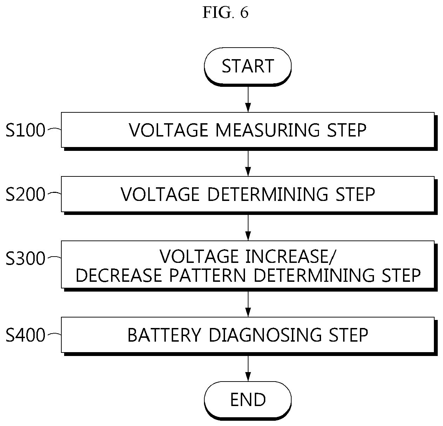

FIG. 6 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

Referring to FIG. 6, the method for diagnosing a battery includes a voltage measuring step, a voltage determining step, a voltage increase/decrease pattern determining step, and a battery diagnosing step.

The voltage measuring step is a step of measuring a voltage of a battery module and each of a plurality of battery cells, and may be performed by the measuring unit 110.

The voltage determining step is a step of determining a voltage of each of the plurality of battery cells when the voltage of the battery module reaches a preset cut-off voltage, and may be performed by the control unit 120.

For example, when the voltage of the battery module reaches the charging cut-off voltage, the control unit 120 may determine a charging voltage of each of the plurality of battery cells.

As another example, when the voltage of the battery module reaches a discharging cut-off voltage, the control unit 120 may determine a discharging voltage of each of the plurality of battery cells.

The voltage increase/decrease pattern determining step is a step of determining a voltage increase/decrease pattern of each of the plurality of battery cells based on the determined plurality of voltages and previously stored voltage data, and may be performed by the control unit 120.

For example, the control unit 120 may determine a first voltage increase/decrease pattern and a second voltage increase/decrease pattern for each of the plurality of battery cells.

Specifically, the control unit 120 may determine the first voltage increase/decrease pattern based on the charging voltage of the battery cell and a reference charging voltage for the corresponding battery cell among previously stored voltage data. Additionally, the control unit 120 may determine the second voltage increase/decrease pattern based on the discharging voltage of the battery cell and a reference discharging voltage for the corresponding battery cell among the previously stored voltage data. Here, the first voltage increase/decrease pattern and the second voltage increase/decrease pattern may be determined as a voltage maintenance pattern, a voltage increase pattern, or a voltage decrease pattern, and may be independent of each other.

The battery diagnosing step is a step of diagnosing the state of each of the plurality of battery cells according to the determined voltage increase/decrease pattern, and may be performed by the control unit 120.

For example, when the capacity of the battery module decreases, the control unit 120 may diagnose the state of the battery cell in which the first voltage increase/decrease pattern is a voltage increase pattern and the second voltage increase/decrease pattern is a voltage decrease pattern as an accelerated deterioration state.

As another example, when the capacity of the battery module decreases, the control unit 120 may diagnose the state of the battery cell in which the first voltage increase/decrease pattern is a voltage decrease pattern and the second voltage increase/decrease pattern is a voltage increase pattern as a slow deterioration state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure as defined by the appended claims, and the present disclosure is not limited to the above-described embodiments and the accompanying drawings, and each embodiment may be selectively combined in part or in whole to allow various modifications.

### (Explanation of reference signs)

1: battery pack
100: apparatus for diagnosing a battery
110: measuring unit
120: control unit
130: storage unit
BM: battery module
B1 to B4: first to fourth battery cells

## Claims

1. An apparatus (100) for diagnosing a battery, which diagnoses states of a plurality of battery cells (B1, B2, B3, B4) included in a battery module (BM), comprising:
a measuring unit (110) configured to measure voltages of the battery module and each of the plurality of battery cells; and
a control unit (120) configured to determine a voltage of each of the plurality of battery cells when the voltage of the battery module reaches a preset cut-off voltage, determine a voltage increase/decrease pattern of each of the plurality of battery cells based on the determined plurality of voltages and previously stored voltage data, and diagnose the state of each of the plurality of battery cells according to the determined voltage increase/decrease pattern.

2. The apparatus for diagnosing a battery according to claim 1,
wherein the previously stored voltage data is set to include a reference voltage of the plurality of battery cells measured each time the voltage of the battery module reaches the cut-off voltage, and
wherein the control unit is configured to determine the voltage increase/decrease pattern for each of the plurality of battery cells based on the determined voltage and at least one reference voltage included in the previously stored voltage data.

3. The apparatus for diagnosing a battery according to claim 2,
wherein the control unit is configured to derive a relationship between the determined voltage and the at least one reference voltage for each of the plurality of battery cells, and determine the voltage increase/decrease pattern for each of the plurality of battery cells based on the derived relationship.

4. The apparatus for diagnosing a battery according to claim 1,
wherein the control unit is configured to diagnose the state of the battery cell depending on whether the determined voltage increase/decrease pattern is toward the cut-off voltage.

5. The apparatus for diagnosing a battery according to claim 1,
wherein the control unit is configured to:
determine a charging voltage of each of the plurality of battery cells when the voltage of the battery module reaches a preset charging cut-off voltage, and determine a first voltage increase/decrease pattern of each of the plurality of battery cells based on the determined charging voltage and the previously stored voltage data,
determine a discharging voltage of each of the plurality of battery cells when the voltage of the battery module reaches a preset discharging cut-off voltage, and determine a second voltage increase/decrease pattern of each of the plurality of battery cells based on the determined discharging voltage and the previously stored voltage data, and
diagnose the state of each of the plurality of battery cells based on the first voltage increase/decrease pattern and the second voltage increase/decrease pattern.

6. The apparatus for diagnosing a battery according to claim 5,
wherein the control unit is configured to:
diagnose the state of a battery cell in which the first voltage increase/decrease pattern is a voltage increase pattern and the second voltage increase/decrease pattern is a voltage decrease pattern as an accelerated deterioration state, and
diagnose the state of a battery cell in which the first voltage increase/decrease pattern is a voltage decrease pattern and the second voltage increase/decrease pattern is a voltage increase pattern as a slow deterioration state.

7. The apparatus for diagnosing a battery according to claim 1,
wherein the measuring unit is configured to further measure a current of the battery module, and
wherein the control unit is configured to calculate a capacity of the battery module based on the current of the battery module, and diagnose the state of each of the plurality of battery cells when the calculated capacity is reduced compared to a previously calculated capacity.

8. The apparatus for diagnosing a battery according to claim 7,
wherein the control unit is configured to diagnose the state of the remaining battery cells among the plurality of battery cells, excluding battery cells whose determined voltage is the same as the cut-off voltage, when the capacity of the battery module is within a preset range from a preset initial capacity.

9. A battery pack, comprising the apparatus for diagnosing a battery according to any one of claims 1 to 8.

10. A method for diagnosing a battery, which diagnoses states of a plurality of battery cells included in a battery module, comprising:
a voltage measuring step (S100) of measuring voltages of the battery module and each of the plurality of battery cells;
a voltage determining step (S200) of determining a voltage of each of the plurality of battery cells when the voltage of the battery module reaches a preset cut-off voltage;
a voltage increase/decrease pattern determining step (S300) of determining a voltage increase/decrease pattern of each of the plurality of battery cells based on the determined plurality of voltages and previously stored voltage data; and
a battery diagnosing step (S400) of diagnosing the state of each of the plurality of battery cells according to the determined voltage increase/decrease pattern.

## Patentansprüche

1. Vorrichtung (100) zum Diagnostizieren einer Batterie, die Zustände von mehreren Batteriezellen (B1, B2, B3, B4), welche in einem Batteriemodul (BM) enthalten sind, diagnostiziert, wobei die Vorrichtung aufweist:
eine Messeinheit (110), die konfiguriert ist, Spannungen des Batteriemoduls und jeder der mehreren Batteriezellen zu messen; und
eine Steuereinheit (120), die konfiguriert ist, eine Spannung von jeder der mehreren Batteriezellen zu bestimmen, wenn die Spannung des Batteriemoduls eine voreingestellte Abschaltspannung erreicht, ein Spannungserhöhungs-/-verringerungsmuster von jeder der mehreren Batteriezellen basierend auf den bestimmten mehreren Spannungen und zuvor gespeicherten Spannungsdaten zu bestimmen, und den Zustand von jeder der mehreren Batteriezellen gemäß dem bestimmten Spannungserhöhungs-/-verringerungsmuster zu diagnostizieren.

2. Vorrichtung zum Diagnostizieren einer Batterie nach Anspruch 1,
wobei die zuvor gespeicherten Spannungsdaten so eingestellt sind, dass sie eine Referenzspannung der mehreren Batteriezellen enthalten, die jedes Mal gemessen wird, wenn die Spannung des Batteriemoduls die Cutoff-Spannung erreicht, und
wobei die Steuereinheit konfiguriert ist, das Spannungserhöhungs-/- verringerungsmuster für jede der mehreren Batteriezellen basierend auf der bestimmten Spannung und mindestens einer Referenzspannung, die in den zuvor gespeicherten Spannungsdaten enthalten ist, zu bestimmen.

3. Vorrichtung zum Diagnostizieren einer Batterie nach Anspruch 2,
wobei die Steuereinheit konfiguriert ist, eine Beziehung zwischen der bestimmten Spannung und der mindestens einen Referenzspannung für jede der mehreren Batteriezellen abzuleiten, und das Spannungserhöhungs-/-verringerungsmuster für jede der mehreren Batteriezellen basierend auf der abgeleiteten Beziehung zu bestimmen.

4. Vorrichtung zum Diagnostizieren einer Batterie nach Anspruch 1,
wobei die Steuereinheit konfiguriert ist, den Zustand der Batteriezelle in Abhängigkeit davon zu diagnostizieren, ob das bestimmte Spannungserhöhungs-/-verringerungsmuster in Richtung der Abschaltspannung ist.

5. Vorrichtung zum Diagnostizieren einer Batterie nach Anspruch 1,
wobei die Steuereinheit konfiguriert ist:
eine Ladespannung von jeder der mehreren Batteriezellen zu bestimmen, wenn die Spannung des Batteriemoduls eine voreingestellte Ladeabschaltspannung erreicht, und ein erstes Spannungserhöhungs-/-verringerungsmuster von jeder der mehreren Batteriezellen basierend auf der bestimmten Ladespannung und den zuvor gespeicherten Spannungsdaten zu bestimmen,
eine Entladespannung von jeder der mehreren Batteriezellen zu bestimmen, wenn die Spannung des Batteriemoduls eine voreingestellte Entladeabschaltspannung erreicht, und ein zweites Spannungserhöhungs-/-verringerungsmuster von jeder der mehreren Batteriezellen basierend auf der bestimmten Entladespannung und den zuvor gespeicherten Spannungsdaten zu bestimmen, und
den Zustand von jeder der mehreren Batteriezellen basierend auf dem ersten Spannungserhöhungs-/-verringerungsmuster und dem zweiten Spannungserhöhungs-/- verringerungsmuster zu diagnostizieren.

6. Vorrichtung zum Diagnostizieren einer Batterie nach Anspruch 5,
wobei die Steuereinheit konfiguriert ist:
den Zustand einer Batteriezelle, in der das erste Spannungserhöhungs-/- verringerungsmuster ein Spannungserhöhungsmuster ist und das zweite Spannungserhöhungs-/-verringerungsmuster ein Spannungsverringerungsmuster ist, als einen beschleunigten Verschlechterungszustand zu diagnostizieren, und
den Zustand einer Batteriezelle, in der das erste Spannungserhöhungs-/- verringerungsmuster ein Spannungsverringerungsmuster ist und das zweite Spannungserhöhungs-/-verringerungsmuster ein Spannungserhöhungsmuster ist, als einen langsamen Verschlechterungszustand zu diagnostizieren.

7. Vorrichtung zum Diagnostizieren einer Batterie nach Anspruch 1,
wobei die Messeinheit konfiguriert ist, ferner einen Strom des Batteriemoduls zu messen, und
wobei die Steuereinheit konfiguriert ist, eine Kapazität des Batteriemoduls basierend auf dem Strom des Batteriemoduls zu berechnen und den Zustand von jeder der mehreren Batteriezellen zu diagnostizieren, wenn die berechnete Kapazität im Vergleich zu einer zuvor berechneten Kapazität verringert ist.

8. Vorrichtung zum Diagnostizieren einer Batterie nach Anspruch 7,
wobei die Steuereinheit konfiguriert ist, den Zustand der verbleibenden Batteriezellen unter den mehreren Batteriezellen zu diagnostizieren, mit Ausnahme von Batteriezellen, deren bestimmte Spannung die gleiche wie die Abschaltspannung ist, wenn die Kapazität des Batteriemoduls innerhalb eines voreingestellten Bereichs von einer voreingestellten Anfangskapazität liegt.

9. Batteriepack, der die Vorrichtung zum Diagnostizieren einer Batterie nach einem der Ansprüche 1 bis 8 aufweist.

10. Verfahren zum Diagnostizieren einer Batterie, das Zustände von mehreren Batteriezellen diagnostiziert, die in einem Batteriemodul enthalten sind, wobei das Verfahren umfasst:
einen Spannungsmessschritt (S100) zum Messen von Spannungen des Batteriemoduls und jeder der mehreren Batteriezellen;
einen Spannungsbestimmungsschritt (S200) zum Bestimmen einer Spannung von jeder der mehreren Batteriezellen, wenn die Spannung des Batteriemoduls eine voreingestellte Abschaltspannung erreicht;
einen Spannungserhöhungs-/-verringerungsmusterbestimmungsschritt (S300) zum Bestimmen eines Spannungserhöhungs-/-verringerungsmusters von jeder der mehreren Batteriezellen basierend auf den bestimmten mehreren Spannungen und zuvor gespeicherten Spannungsdaten; und
einen Batteriediagnoseschritt (S400) zum Diagnostizieren des Zustands von jeder der mehreren Batteriezellen gemäß dem bestimmten Spannungserhöhungs-/- verringerungsmuster.

## Revendications

1. Appareil (100) pour effectuer le diagnostic d'une batterie, qui diagnostique les états d'une pluralité de cellules de batterie (B1, B2, B3, B4) incluses dans un module de batterie (BM), comprenant :
une unité de mesure (110) configurée pour mesurer les tensions du module de batterie et de chaque cellule de la pluralité de cellules de batterie ; et
une unité de commande (120) configurée pour déterminer une tension de chaque cellule de la pluralité de cellules de batterie lorsque la tension du module de batterie atteint une tension de coupure préréglée, déterminer un modèle d'accroissement/de diminution de tension de chaque cellule de la pluralité de cellules de batterie sur la base de la pluralité de tensions déterminées et de données de tension stockées antérieurement, et diagnostiquer l'état de chaque cellule de la pluralité de cellules de batterie en fonction du modèle d'accroissement/de diminution de tension déterminé.

2. Appareil pour effectuer le diagnostic d'une batterie selon la revendication 1,
dans lequel les données de tension stockées antérieurement devraient inclure une tension de référence de la pluralité de cellules de batterie mesurée chaque fois que la tension du module de batterie atteint la tension de coupure, et
dans lequel l'unité de commande est configurée pour déterminer le modèle d'accroissement/de diminution de tension pour chaque cellule de la pluralité de cellules de batterie sur la base de la tension déterminée et d'au moins une tension de référence incluse dans les données de tension stockées antérieurement.

3. Appareil pour effectuer le diagnostic d'une batterie selon la revendication 2,
dans lequel l'unité de commande est configurée pour dériver une relation entre la tension déterminée et l'au moins une tension de référence pour chaque cellule de la pluralité de cellules de batterie, et déterminer le modèle d'accroissement/de diminution de tension pour chaque cellule de la pluralité de cellules de batterie sur la base de la relation dérivée.

4. Appareil pour effectuer le diagnostic d'une batterie selon la revendication 1,
dans lequel l'unité de commande est configurée pour diagnostiquer l'état de la cellule de batterie en fonction du fait de savoir si le modèle d'accroissement/de diminution de tension tend vers la tension de coupure.

5. Appareil pour effectuer le diagnostic d'une batterie selon la revendication 1,
dans lequel l'unité de commande est configurée pour :
déterminer une tension de charge de chaque cellule de la pluralité de cellules de batterie lorsque la tension du module de batterie atteint une tension de coupure de charge préréglée, et déterminer un premier modèle d'accroissement/de diminution de tension de chaque cellule de la pluralité de cellules de batterie sur la base de la tension de charge déterminée et des données de tension stockées antérieurement,
déterminer une tension de décharge de chaque cellule de la pluralité de cellules de batterie lorsque la tension du module de batterie atteint une tension de coupure de décharge préréglée, et déterminer un deuxième modèle d'accroissement/de diminution de tension de chaque cellule de la pluralité de cellules de batterie sur la base de la tension de décharge déterminée et des données de tension stockées antérieurement, et
diagnostiquer l'état de chaque cellule de la pluralité de cellules de batterie sur la base du premier modèle d'accroissement/de diminution de tension et du deuxième modèle d'accroissement/de diminution de tension.

6. Appareil pour effectuer le diagnostic d'une batterie selon la revendication 5,
dans lequel l'unité de commande est configurée pour :
diagnostiquer l'état d'une cellule de batterie dans laquelle le premier modèle d'accroissement/de diminution de tension est un modèle d'accroissement de tension et le deuxième modèle d'accroissement/de diminution de tension est un modèle de diminution de tension comme étant un état de détérioration accélérée, et
diagnostiquer l'état d'une cellule de batterie dans laquelle le premier modèle d'accroissement/de diminution de tension est un modèle de diminution de tension et le deuxième modèle d'accroissement/de diminution de tension est un modèle d'accroissement de tension comme étant un état de détérioration lente.

7. Appareil pour effectuer le diagnostic d'une batterie selon la revendication 1,
dans lequel l'unité de mesure est configurée pour mesurer en outre un courant du module de batterie, et
dans lequel l'unité de commande est configurée pour calculer une capacité du module de batterie sur la base du courant du module de batterie, et diagnostiquer l'état de chaque cellule de la pluralité de cellules de batterie lorsque la capacité calculée est réduite en comparaison avec une capacité calculée antérieurement.

8. Appareil pour effectuer le diagnostic d'une batterie selon la revendication 7,
dans lequel l'unité de commande est configurée pour diagnostiquer l'état des cellules de batterie restantes parmi la pluralité de cellules de batterie, à l'exclusion des cellules de batterie dont la tension déterminée est la même que la tension de coupure, lorsque la capacité du module de batterie se situe dans les limites d'une plage préréglée à partir d'une capacité initiale préréglée.

9. Bloc-batterie, comprenant l'appareil pour effectuer le diagnostic d'une batterie selon n'importe laquelle des revendications 1 à 8.

10. Procédé pour effectuer le diagnostic d'une batterie, qui diagnostique les états d'une pluralité de cellules de batterie incluses dans un module de batterie, comprenant :
une étape de mesure de tension (S100) consistant à mesurer les tensions du module de batterie et de chaque cellule de la pluralité de cellules de batterie ;
une étape de détermination de tension (S200) consistant à déterminer une tension de chaque cellule de la pluralité de cellules de batterie lorsque la tension du module de batterie atteint une tension de coupure préréglée ;
une étape de détermination du modèle d'accroissement/de diminution de tension (S300) consistant à déterminer un modèle d'accroissement/de diminution de tension de chaque cellule de la pluralité de cellules de batterie sur la base de la pluralité déterminée de tensions et de données de tension stockées antérieurement ; et
une étape de diagnostic de batterie (S400) consistant à diagnostiquer l'état de chaque cellule de la pluralité de cellules de batterie en fonction du modèle d'accroissement/de diminution de tension déterminé.
